# FASCICULE DE BREVET EUROPEEN

(11) **EP 2 396 446 B1**
(45) Date de publication et mention de la délivrance du brevet: **21.08.2019**
(21) Numéro de dépôt: 10708289.3
(22) Date de dépôt: 05.02.2010
(51) Int. Cl.: C23C 4/02, C23C 4/18, C23C 28/00, C23C 14/02, C23C 14/58

(54) **MÉTHODE DE FABRICATION D'UNE BARRIÈRE THERMIQUE RECOUVRANT UN SUBSTRAT MÉTALLIQUE EN SUPERALLIAGE ET PIÈCE THERMOMÉCANIQUE RÉSULTANT DE CETTE MÉTHODE DE FABRICATION**
VERFAHREN ZUR HERSTELLUNG EINER WÄRMEBARRIERE AUF EINEM METALLSUBSTRAT AUS EINER SUPERLEGIERUNG UND AUS DEM HERSTELLUNGSVERFAHREN RESULTIERENDES THERMOMECHANISCHES TEIL
METHOD FOR PRODUCING A THERMAL BARRIER COVERING A METAL SUBSTRATE MADE OF A SUPERALLOY, AND THERMOMECHANICAL PART RESULTING FROM SAID PRODUCTION METHOD

(30) Priorité: 10.02.2009 FR 0900570
(43) Date de publication de la demande: 21.12.2011
(73) Titulaire: Safran Aircraft Engines, 75015 Paris (FR)
(72) Inventeur: CADORET, Yannick, F-78310 Maurepas (FR); HERVIER, Samuel, F-86440 Migne-Auxances (FR); MONS, Claude, F-77176 Savigny Le Temple (FR); PASQUET, Annie, F-91160 Longjumeau (FR)
(74) Mandataire: Cardy, Sophie Marie
(86) Numéro de dépôt international: PCT/FR2010/050189
(87) Numéro de publication internationale: WO 2010/092280

(56) Documents cités:
- US-A- 4 321 310
- US-A- 5 866 271
- US-B1- 6 340 500
- US-B1- 6 482 469

## Description

L'invention concerne une méthode de fabrication ou de réparation d'une barrière thermique recouvrant un substrat métallique en superalliage, ainsi que la pièce thermomécanique résultant de cette méthode de fabrication.

La recherche de l'augmentation du rendement des turbomachines, en particulier dans le domaine aéronautique, et de la diminution de la consommation en carburant et des émissions polluantes de gaz et d'imbrûlés ont conduit à se rapprocher de la stoechiométrie de combustion du carburant. Cette situation s'accompagne d'une augmentation de la température des gaz sortant de la chambre de combustion en direction de la turbine.

Aujourd'hui, la température limite d'utilisation des superalliages est de l'ordre de 1100°C, la température des gaz en sortie de chambre de combustion ou en entrée de turbine pouvant atteindre 1600°C.

En conséquence, il a fallu adapter les matériaux de la turbine à cette élévation de température, en perfectionnant les techniques de refroidissement des aubes de turbines (aubes creuses) et/ou en améliorant les propriétés de résistance aux températures élevées de ces matériaux. Cette deuxième voie, en combinaison avec l'utilisation des superalliages à base de nickel et/ou de cobalt, a conduit à plusieurs solutions parmi lesquelles le dépôt d'un revêtement isolant thermique dénommé barrière thermique composé de plusieurs couches, sur le substrat en superalliage.

L'utilisation des barrières thermiques dans les moteurs aéronautiques s'est généralisée depuis une vingtaine d'années et permet d'augmenter la température d'entrée des gaz dans les turbines, de réduire le flux d'air de refroidissement et ainsi d'améliorer le rendement des moteurs.

En effet, ce revêtement isolant permet de créer sur une pièce refroidie, en régime permanent de fonctionnement, un gradient thermique au travers du revêtement, dont l'amplitude totale peut dépasser 100°C pour un revêtement de 150 à 200 µm d'épaisseur environ présentant une conductivité de 1.1 W.m⁻¹.K⁻¹. La température de fonctionnement du métal sous-jacent formant le substrat pour le revêtement se trouve diminuée du même gradient, ce qui induit des gains important sur le volume d'air de refroidissement nécessaire, la durée de vie de la pièce et la consommation spécifique du moteur à turbine.

Il est connu de recourir à l'utilisation d'une barrière thermique comprenant une couche de céramique à base de zircone stabilisée à l'oxyde d'Yttrium qui présente un coefficient de dilatation différent du superalliage constituant le substrat et une conductivité thermique assez faible. La zircone stabilisée peut également contenir dans certains cas au moins un oxyde d'un élément choisi dans le groupe constitué de terres rares, de préférence dans le sous-groupe : Y (yttrium), Dy (dysprosium), Er (erbium), Eu (europium), Gd (gadolinium), Sm (samarium), Yb (ytterbium), ou une combinaison d'un oxyde de tantale (Ta) et d'au moins un oxyde de terre rare, ou avec une combinaison d'un oxyde de niobium (Nb) et d'au moins un oxyde de terre rare.

Afin d'assurer l'ancrage de cette couche de céramique, une sous-couche métallique, avec un coefficient de dilation proche du substrat, est généralement interposée entre le substrat de la pièce et la couche de céramique, comme décrit dans le document US 4 321 310. Cette sous-couche assure l'adhérence entre le substrat de la pièce et la couche de céramique, sachant que l'adhérence entre la sous-couche et le substrat de la pièce se fait par inter-diffusion, et que l'adhérence entre la sous-couche et la couche de céramique se fait par ancrage mécanique et par la propension de la sous-couche à développer à haute température, à l'interface céramique/sous-couche, une couche d'oxyde mince qui assure le contact chimique avec la céramique. En outre, cette sous-couche métallique assure la protection de la pièce contre les phénomènes de corrosion.

Parmi les revêtements utilisés, on citera l'utilisation assez générale d'une couche de céramique à base de zircone partiellement stabilisée à l'oxyde d'yttrium, par exemple Zr_{0.92} Y_{0,08}O_{1,96}.

En particulier, il est connu d'utiliser, selon des procédé connus (Air Plasma Spray, Very Low Pressure Plasma Spray) une sous-couche formée d'un alliage de type MCrAlY, M étant un métal choisi parmi le nickel, le cobalt, le fer ou un mélange de ces métaux, qui consiste en une matrice gamma-gamma prime de nickel cobalt avec, en solution, du chrome contenant des précipités β NiAl.

Il est également connu d'utiliser une sous-couche, constituée par exemple d'un aluminiure de nickel, comprenant un métal choisi parmi le platine, le chrome, le palladium, le ruthénium, l'iridium, l'osmium, le rhodium, ou un mélange de ces métaux et/ou un élément réactif choisi parmi le zirconium (Zr), le cerium (Ce), le lanthane (La), le titane (Ti), le tantale (Ta), l'hafnium (Hf), le silicium (Si) et l'yttrium (Y). Par exemple, on utilise un revêtement de type Ni₍₁₋ₓ₎PtₓAl, dans lequel le platine est en insertion dans le réseau du nickel. Le platine est déposé par voie électrolytique avant le traitement thermochimique d'aluminisation.

Cette sous-couche métallique peut également être constituée d'un aluminiure de nickel modifié platine (Ni, Pt)Al, selon un procédé comprenant les étapes suivantes: la préparation de la surface de la pièce par décapage chimique et sablage; le dépôt sur la pièce, par électrolyse, d'un revêtement de platine (Pt); le traitement thermique éventuel de l'ensemble pour faire diffuser le Pt dans la pièce; le dépôt d'aluminium (Al) par dépôt chimique en phase vapeur (CVD) ou par dépôt physique en phase vapeur (PVD); le traitement thermique éventuel de l'ensemble pour faire diffuser Pt et Al dans la pièce; la préparation de la surface de la sous-couche métallique formée; et le dépôt par évaporation sous faisceau d'électrons (EB-PVD) d'un revêtement en céramique.

Cette sous-couche peut correspondre enfin à un revêtement de platine diffusé seul qui consiste en une matrice gamma-gamma prime de nickel cobalt avec du Pt en solution.

Egalement, il est parfois mis en oeuvre, pour l'obtention d'un revêtement et/ou de la sous-couche du revêtement, une étape consistant à modifier la surface de la pièce en superalliage en déposant une couche de platine de plus de 10 micromètres puis à effectuer un traitement thermique de diffusion.

Aussi, la société demanderesse utilise un revêtement thermochimique dénommé C1A formé par un revêtement d'aluminiure modifié par du chrome et résultant de la réalisation successives de deux étapes de dépôt en phase vapeur : une première étape de dépôt d'une couche de 2 à 6 micromètres de chrome suivie d'une étape d'aluminisation.

Un tel revêtement est plutôt utilisé comme revêtement pour protéger les pièces de l'oxydation ou de la corrosion à chaud, ou, éventuellement, comme sous-couche de barrière thermique.

De façon traditionnelle, l'utilisation d'une sous-couche métallique comprenant de l'aluminium engendre par oxydation naturelle à l'air une couche d'alumine Al₂O₃ qui recouvre toute la sous-couche.

Habituellement, la couche de céramique est déposée sur la pièce à revêtir soit par une technique de projection (en particulier projection plasma) ou de dépôt par voie physique en phase vapeur, c'est-à-dire par évaporation (par exemple par EB-PVD ou « Electron Beam Physical Vapour Déposition » formant un revêtement déposé dans une enceinte d'évaporation sous vide sous bombardement électronique).

Dans le cas d'un revêtement projeté, un dépôt d'oxyde à base de zircone est effectué par des techniques du type projection plasma sous atmosphère contrôlée, ce qui conduit à la formation d'un revêtement constitué d'un empilement de gouttelettes fondues puis trempées par choc, aplaties et empilées de façon à former un dépôt densifié de manière imparfaite d'une épaisseur généralement comprise entre 50 micromètres et 1 millimètre.

Un revêtement déposé par voie physique, par exemple par évaporation sous bombardement électronique, engendre un revêtement constitué d'un assemblage de colonnettes dirigées sensiblement de manière perpendiculaire à la surface à revêtir, sur une épaisseur comprise entre 20 et 600 micromètres. Avantageusement, l'espace entre les colonnettes permet au revêtement de compenser efficacement les sollicitations thermomécaniques dues, aux températures de service, au différentiel de dilatation avec le substrat en superalliage.

Ainsi, on obtient des pièces avec des durées de vie élevées en fatigue thermique à haute température.

Classiquement, ces barrières thermiques créent donc une discontinuité de conductivité thermique entre le revêtement extérieur de la pièce mécanique, formant cette barrière thermique, et le substrat de ce revêtement formant le matériau constitutif de la pièce.

De manière habituelle, on constate que les barrières thermiques qui engendrent une discontinuité importante de conductivité thermique sont en contrepartie génératrices d'un risque de délaminage important entre le revêtement et le substrat, ou plus précisément à l'interface entre la sous-couche et la couche en céramique. Cette situation conduit à l'écaillage de la couche de céramique, de sorte que le substrat n'étant plus (localement) protégé par la couche de céramique isolante, il est soumis à de plus forte températures et s'endommage alors très rapidement.

Cet endommagement résulte en partie du phénomène appelé couramment « rumpling » qui se produit au cours des cycles de variation importante de température auxquels les matériaux sont soumis après mise en service des moteurs, et qui touchent en particulier les aubes de turbine.

Ce phénomène conduit à une déformation de la sous-couche et résulte de différents paramètres. Le « rumpling » peut s'expliquer par :
- L'état de surface initial qui joue un rôle capital sur l'adhérence de la céramique en service ;
- La différence des coefficients de dilatation entre la sous-couche et le superalliage qui conduit à une déformation progressive du revêtement lors des cycles successifs à haute température ;
- Les transformation de phase β-(Ni,Pt)Al→γ'-Ni₃Al et phénomènes d'interdiffusion entre le substrat métalllique et le revêtement ;
- Les transformation martensitique de la phase β-(Ni,Pt)Al, qui se produit au refroidissement, pour des teneurs en aluminium inférieures à 37%atomique ;
- Les contraintes de croissance dans la couche d'alumine ; et
- La composition chimique du substrat (effet des éléments réactifs).

Il est reconnu dans la littérature que le phénomène de « rumpling » est un mécanisme de dégradation inévitable sur les systèmes de barrière thermique. Ainsi l'article de référence « Temperature and cycle-time dependence of rumpling in platinum-modified diffusion aluminide coatings » (V.K. Tolpygo and D. R. Clarke, Scripta Materialia 57 (2007, 563-566), montre clairement l'effet de la température, de la fréquence et de la durée des cycles thermiques, ces paramètres étant des facteurs significatifs sur l'évolution du phénomène de « rumpling » à haute température. Selon les auteurs, ce phénomène de déformation de la sous-couche est directement lié à la température et reste inévitable pour des températures supérieures à 1100°C.

De nombreuses tentatives de l'art antérieur pour éviter ou retarder l'apparition du phénomène de « rumpling » sont basées sur des modifications de la composition chimique du substrat en superalliage. Ainsi, l'article « Effect of Hf, Y and C in the underlying superalloy on the rumpling of diffusion aluminide coatings», Tolpygo V.K. et al, Acta Materialia, 56 (2008), pages 489-499, présente la décohésion de la barrière thermique résultant du phénomène de « rumpling » comme inévitable et constate une modification du moment de son apparition en fonction de la teneur en hafnium et en carbone dans le superalliage.

De la même façon Spitsberg et al. dans l'article « On the failure mechanisms of thermal barrier coatings with diffusion aluminide bond coatings », Materials Science and Engineering, A 394 (2005), pages 176-191 » ont mis en évidence que l'utilisation d'un substrat enrichi en rhénium peut modifier la durée de vie à l'écaillage pour un traitement de surface identique. L'effet du rhénium semble modifier le temps d'apparition du phénomène de « rumpling » mais ne peut en aucun le supprimer totalement.

La présente invention a donc pour objectif de proposer une méthode de fabrication de barrière thermique et une structure de barrière thermique résultant de cette méthode qui empêche ou retarde l'apparition du phénomène de « rumpling » ou minimise son importance.

L'invention a également pour objectif de fournir une pièce thermomécanique en superalliage résultant de cette méthode de fabrication qui limite l'endommagement de la sous-couche résultant du phénomène de « rumpling » lors du fonctionnement de la pièce, en particulier une aube, à haute température et ce, afin d'augmenter significativement la durée de vie à l'écaillage du système de barrière thermique .

A cet effet, selon la présente invention, la méthode de fabrication est caractérisée en ce l'on met en oeuvre l'étape suivante :
- on rectifie l'état de surface de la sous-couche par au moins un procédé physico-chimique et/ou mécanique avant d'effectuer le dépôt de la couche de céramique de sorte que le nombre de défauts présentant un écart entre les crêtes (entre le fond d'un creux et le sommet d'un pic) supérieur ou égal à 2 µm est au maximum de 5 sur toute distance (pas ou étendue) de 50 µm, et on effectue le dépôt de la couche de céramique.

De cette manière, on comprend que les conditions à remplir pour atteindre cet objectif correspondent au cumul des deux conditions suivantes :
- état de surface de la sous-couche présentant une rugosité contrôlée avec une densité surfacique de « gros défauts » limitée, et
- présence de la couche de céramique sur la sous-couche (directement sur la sous-couche ou avec interposition d'une couche d'alumine).

En effet, avec une rugosité qui respecte les conditions décrites dans la présente demande de brevet, et en présence de la couche de céramique, le demandeur a trouvé que le phénomène de « rumpling » était inexistant ou tout au moins fortement limité, alors qu'un préjugé existait quant au fait de pouvoir écarter le phénomène de « rumpling » en ayant notamment recours à une modification de l'état de surface de la sous-couche ou de la modification de la composition chimique de la sous-couche.

Les explications que le demandeur donne sur la performance inattendue des barrières thermiques issues de la méthode de fabrication conforme à l'invention résident notamment dans le fait qu'un effet de synergie est obtenu : l'état de surface optimisé de la sous-couche permet d'un côté d'avoir un bon accrochage de la couche de céramique et de l'autre côté de limiter le nombre d'occurrences des défauts (creux ou crêtes) d'amplitude importante autant sur la surface de la sous-couche qu'à la surface de la couche de céramique ce qui évite de créer des foyers de délaminage, et par ailleurs la couche de céramique rigidifie la barrière thermique et garantit une protection des couches de matériau situées en dessous contre les hautes températures. La présence de la couche céramique empêche toute déformation de la sous-couche métallique, si et uniquement si l'état de surface est optimisée selon les paramètres donnés ci-dessous.

Globalement, grâce à la solution selon la présente invention, il est possible d'augmenter la durée de vie de la barrière thermique et de la pièce revêtue de cette barrière thermique en inhibant le phénomène de « rumpling » pendant le service de la pièce.

Cette solution présente aussi l'avantage supplémentaire, de permettre une mise en oeuvre aisée et reproductible.

La solution selon la présente invention va à l'encontre d'un préjugé relatif à l'impossibilité d'éviter le phénomène de « rumpling » et ce résultat est rendu possible par la détermination de conditions à respecter pour l'ensemble formé par la sous-couche et la couche de céramique, sans se limiter aux caractéristiques de la sous-couche seule ou de la céramique seule.

La présente invention s'applique non seulement dans le cas de la réalisation d'une barrière thermique pour la fabrication initiale d'une pièce thermomécanique, mais également pour la réparation de la barrière thermique. Dans le cas d'une réparation, on effectue au préalable de la mise en oeuvre de la méthode présentée ici, le retrait de la couche de céramique, et éventuellement le retrait de la sous-couche puis le dépôt d'une nouvelle sous couche.

Dans ce cas, les portions de surface réparées selon les conditions déterminées par la présente invention bénéficient des durées de vie augmentées de la barrière thermique ainsi recréée.

Une telle réparation peut s'avérer nécessaire sur des zones d'usure particulières pour certaines pièces, en particulier les bords d'attaque et les bords de fuite pour les aubes dans le domaine aéronautique, que ce soit les aubes de soufflante, de compresseur et/ou de turbine d'un turbomoteur.

L'invention s'applique de préférence à des pièces thermomécaniques présentant un substrat en superalliage à base nickel, notamment à des aubes de turbine monocristallines refroidies par de l'air circulant dans des canaux internes.

L'invention s'applique à des pièces thermomécaniques présentant un substrat dans tout type de superalliage, notamment à base de nickel et/ou de cobalt et/ou Fe.

S'agissant des conditions à respecter pour l'état de surface de la sous-couche, le demandeur a trouvé différentes façon de la caractériser. Ainsi, l'une, l'autre ou plusieurs des dispositions suivantes sont applicables :
- le procédé physico-chimique et/ou mécanique engendre un état de surface de la sous-couche tel que le nombre de défauts (creux ou pics) présentant une amplitude supérieure à 1 µm par rapport à la position moyenne de la face supérieure de la sous-couche (profil moyen ou ligne de surface théorique) est au maximum de 5 sur toute distance (pas ou étendue) de 50 µm ;
- le procédé physico-chimique et/ou mécanique engendre un état de surface de la sous-couche tel que la rugosité Ra de la sous-couche est comprise entre 0.05 µm et 3 µm, et de préférence entre 0.05 µm et 1 µm, avec la rugosité Ra qui est l'écart moyen : il s'agit de l'écart moyen arithmétique par rapport à la ligne moyenne ou la moyenne intégrale des écarts en valeur absolue ;
- le procédé physico-chimique et/ou mécanique engendre un état de surface de la sous-couche tel que la rugosité Rz de la sous-couche est inférieure à 10 µm, avec la rugosité Rz qui est la régularité : il s'agit de la moyenne des écarts totaux de rugosité "Rt" observés sur 5 longueurs, avec "Rt" l'écart total qui correspond à la dénivellation la plus importante entre le plus haut sommet d'un pic et le fond le plus bas d'un creux,
- le procédé physico-chimique et/ou mécanique engendre un état de surface de la sous-couche tel que l'un au moins parmi les critères suivants est respecté :
   0 µm < Rk < 5 µm,
   0 µm < Rvk < 3 µm,
   0 µm < Rpk < 3 µm,
- 1 < Sk < 1, et
   1 < Ek < 10,
   avec les paramètres Rk, Rpk et Rvk calculés sur la base d'une courbe d'Abott, Rk étant la profondeur du profil écrêté qui représente la profondeur de rugosité centrale du profil, Rvk étant la profondeur de creux éliminés qui représente la profondeur moyenne des creux dépassant la partir centrale du profil et Rpk étant la hauteur des crêtes éliminées qui représente la hauteur moyenne des crêtes dépassant la partir centrale du profil, et avec Sk correspondant à la symétrie de la courbe de distribution d'amplitude et Ek le tracé global de référence.

Le procédé physico-chimique et/ou mécanique qui permet d'obtenir l'état de surface recherché appartient de préférence au groupe comprenant le sablage sec, le sablage humide, le polissage mécanique, le polissage électrolytique, et la tribofinition.

Par exemple, pour la tribofinition, on entend des procédés intégrant les techniques de polissage, ébavurage, désoxydation, lissage, dégraissage... Ces procédés comprennent des médias abrasifs (céramique, porcelaine, plastique, métaux), des additifs chimiques et des équipements qui génèrent les mouvements (vibrateurs, centrifugeuses...), dans un environnement chimique contrôlé.

La présente invention porte également sur la pièce thermomécanique résultant de la méthode de fabrication décrite précédemment.

En particulier, la présente invention porte sur une pièce thermomécanique réalisée dans substrat métallique en superalliage, et recouverte d'une barrière thermique comprenant au moins une sous-couche et une couche de céramique, pour laquelle l'une ou plusieurs des dispositions suivantes sont mises en oeuvre :
- la sous-couche est une sous-couche métallique constituée d'un aluminiure de nickel contenant éventuellement un métal choisi parmi le platine, le chrome, le palladium, le ruthénium, l'iridium, l'osmium, le rhodium, ou un mélange de ces métaux et/ou un élément réactif choisi parmi le zirconium (Zr), le cerium (Ce), le lanthane (La), le titane (Ti), le tantale (Ta), l'hafnium (Hf), le silicium (Si) et l'yttrium (Y), en particulier une une sous-couche métallique constituée de NiAlPt, ou une sous-couche (13) métallique de type MCrAlY, M étant un métal choisi parmi le nickel, le cobalt, le fer ou un mélange de ces métaux, ou à base de Pt. Cette sous-couche peut correspondre enfin à un revêtement de platine diffusé seul qui consiste en une matrice gamma-gamma prime de nickel cobalt avec du platine (Pt) en solution.
- ladite sous-couche est constituée d'un alliage apte à former une couche d'alumine protectrice par oxydation, et
- ladite couche de céramique est à base de zircone stabilisée, à savoir une zircone yttriée comprenant une teneur molaire d'oxyde d'yttrium entre 4 et 12%. Cette zircone stabilisé peut également contenir dans certains cas au moins un oxyde d'un élément choisi dans le groupe constitué de terres rares, de préférence dans le sous-groupe : Y (yttrium, Dy (dysprosium), Er (erbium), Eu (europium), Gd (gadolinium), Sm (samarium), Yb (ytterbium), ou une combinaison d'un oxyde de tantale (Ta) et d'au moins un oxyde de terre rare, ou avec une combinaison d'un oxyde de niobium (Nb) et d'au moins un oxyde de terre rare.

La présente invention porte également sur une pièce thermomécanique pour une turbomachine, et notamment, chambre de combustion, aube de turbine, distributeur de turbine, et toute pièce thermomécanique susceptible d'être revêtue d'un système de barrière thermique.

D'autres avantages et caractéristiques de l'invention ressortiront à la lecture de la description suivante faite à titre d'exemple et en référence aux dessins annexés dans lesquels
- la figure 1 est une vue en coupe schématique montrant partiellement une pièce mécanique revêtue d'une barrière thermique ;
- la figure 2 est une coupe micrographique représentant les différentes couches de la barrière thermique à la surface de la pièce ;
- la figure 3 est une vue analogue à celle de la figure 2 pour une pièce ayant été en service, avec endommagement de la barrière thermique ;
- les figures 4A, 4B et 4C représentent différents profils de rugosité correspondants à des états de surface différents de la sous-couche ;
- les figures 5A et 5B sont des coupes micrographiques représentant, à différents grossissements, une barrière thermique de l'art antérieur avant service, et la figure 5C représente le profil de rugosité de la surface correspondante de la sous-couche avant la mise en service ;
- les figures 6A, 6B et 6C sont des vues, avant service à l'état neuf, à différents grossissements, respectivement similaires à celles des figures 5A, 5B et 5C pour une première forme de mise en oeuvre de la méthode conforme à l'invention ;
- les figures 7A, 7B et 7C sont des vues, avant service à l'état neuf, à différents grossissements, respectivement similaires à celles des figures 5A, 5B et 5C pour une deuxième forme de mise en oeuvre de la méthode conforme à l'invention ;
- les figures 8A et 8B sont des coupes micrographiques représentant respectivement une barrière thermique de l'art antérieur après service et une barrière thermique résultant de la deuxième forme de mise en oeuvre de la méthode conforme à l'invention après service, et la figure 8C est un diagramme illustrant les durées de vie à l'écaillage de différentes barrières thermiques ;
- les figures 9A et 9B sont des coupes micrographiques à différents grossissements représentant après service, une barrière thermique pour une mise en oeuvre de la méthode conforme à l'invention ;
- Les figures 10A et 10B sont des coupes micrographiques à différents grossissements pour une mise en oeuvre de la méthode conforme à l'invention présentant une zone de la couche céramique écaillée ; et
- la figure 11 est une illustration du phénomène de « rumpling ».

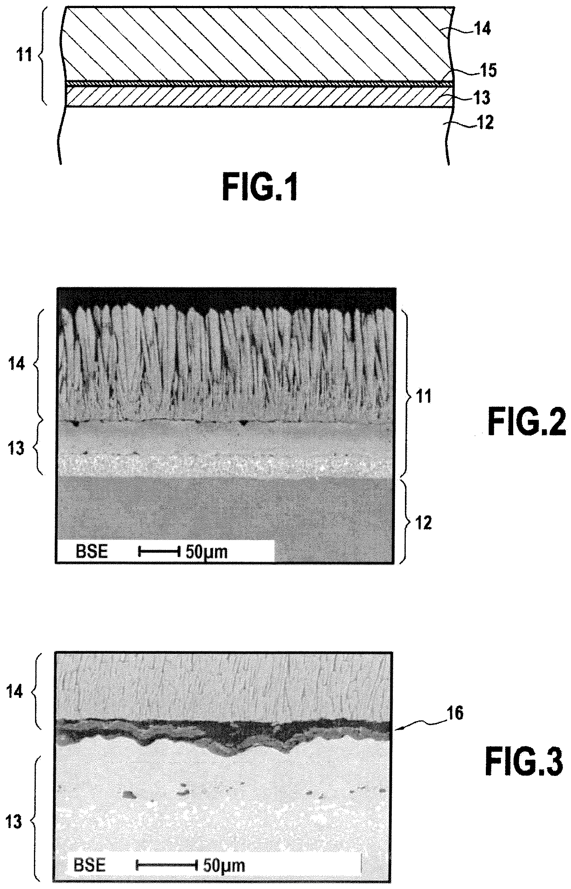

La pièce mécanique représentée partiellement sur la figure 1 comporte un revêtement de barrière thermique 11 déposé sur un substrat 12 en superalliage, tel que les superalliages à base de nickel et/ou de cobalt. Le revêtement de barrière thermique 11 comporte une sous-couche métallique 13 déposée sur le substrat 12, et une couche de céramique 14, déposée sur la sous-couche 13.

La sous-couche de liaison 13 est une sous-couche métallique constituée d'un aluminiure de nickel contenant éventuellement un métal choisi parmi le platine, le chrome, le palladium, le ruthénium, l'iridium, l'osmium, le rhodium, ou un mélange de ces métaux et/ou un élément réactif choisi parmi le zirconium (Zr), le cerium (Ce), le lanthane (La), le titane (Ti), le tantale (Ta), l'hafnium (Hf), le silicium (Si) et l'yttrium (Y), en particulier une une sous-couche métallique constituée de NiAIPt, ou une sous-couche métallique de type MCrAlYPt, M étant un métal choisi parmi le nickel, le cobalt, le fer ou un mélange de ces métaux, ou à base de Pt. Cette sous-couche de liaison 13 peut correspondre enfin à un revêtement de platine diffusé seul qui consiste en une matrice gamma-gamma prime de nickel cobalt avec du platine (Pt) en solution.

La couche de céramique 14 est constituée de zircone yttriée comprenant une teneur molaire d'oxyde d'yttrium entre 4 et 12% (zircone partiellement stabilisée). La zircone stabilisé 14 peut également contenir dans certains cas au moins un oxyde d'un élément choisi dans le groupe constitué de terres rares, de préférence dans le sous-groupe : Y (yttrium), Dy (dysprosium), Er (erbium), Eu (europium), Gd (gadolinium), Sm (samarium), Yb (ytterbium), ou une combinaison d'un oxyde de tantale(Ta) et d'au moins un oxyde de terre rare, ou avec une combinaison d'un oxyde de niobium (Nb) et d'au moins un oxyde de terre rare

Lors de la fabrication, la sous-couche de liaison 13 a été oxydée préalablement au dépôt de la couche de céramique 14, d'où la présence d'une couche intermédiaire d'alumine 15 entre la sous-couche 13 et la couche de céramique 14.

On retrouve sur la vue de la figure 2 les différentes couches précitées, avec une structure colonnaire typique de la couche de céramique 14 présente en surface.

Après service, la pièce (par exemple une aube de turbine) ayant subi des centaines de cycles à haute température (de l'ordre de 1100°C°), la morphologie de la barrière thermique est modifiée comme il apparaît sur la figure 3 :un endommagement est apparu au niveau de l'interface 16 entre la sous-couche 13 et la couche de céramique 14 qui présente une rupture, cette disparition de la liaison entre la sous-couche 13 et la couche de céramique 14 conduisant inévitablement au délaminage et à l'écaillage, c'est-à-dire au départ de la couche de céramique 14.

Dans le cadre de la présente invention, le demandeur a analysé différents profils de rugosité de la sous-couche 13, obtenus après différents traitements de surface (standard de l'art antérieur et gammes optimisées conformes à la présente invention), et les conséquences en termes de durée de vie à l'écaillage lorsque cette sous-couche est revêtue d'une couche de céramique 14.

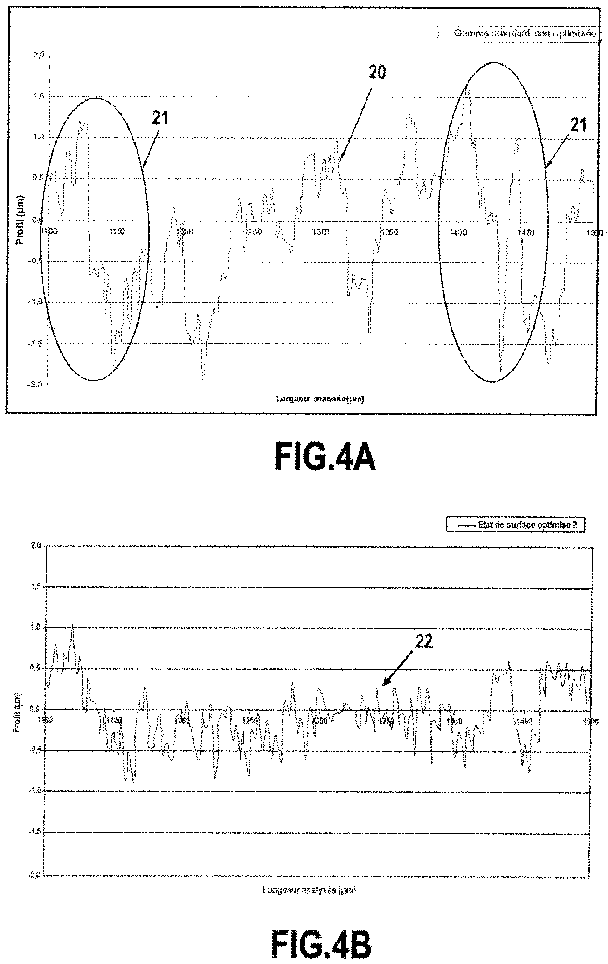

Ainsi la courbe 20 de la figure 4A correspond au profil de rugosité de la sous-couche 13 après un traitement standard de l'art antérieur par sablage avant dépôt de la couche céramique : il y a de nombreux écarts de niveau de la surface autour du profil moyen avec plusieurs « gros défauts » 21 présentant un écart entre les crêtes (distance entre le fond du creux et le sommet de la pointe) de l'ordre de 4 µm.

La courbe 22 de la figure 4B correspond au profil de rugosité de la sous-couche 13 telle qu'elle résulte d'une première forme de mise en oeuvre de la méthode conforme à l'invention utilisant un premier procédé physico-chimique et/ou mécanique permettant de modifier l'état de surface avant dépôt de la couche céramique. Il s'agit d'un sablage sec de quelques minutes à une pression de quelques bars. Comme il apparaît sur la courbe 22 : les écarts de niveau de la surface autour du profil moyen sont de moindre importance et en général de l'ordre de 1 µm au maximum.

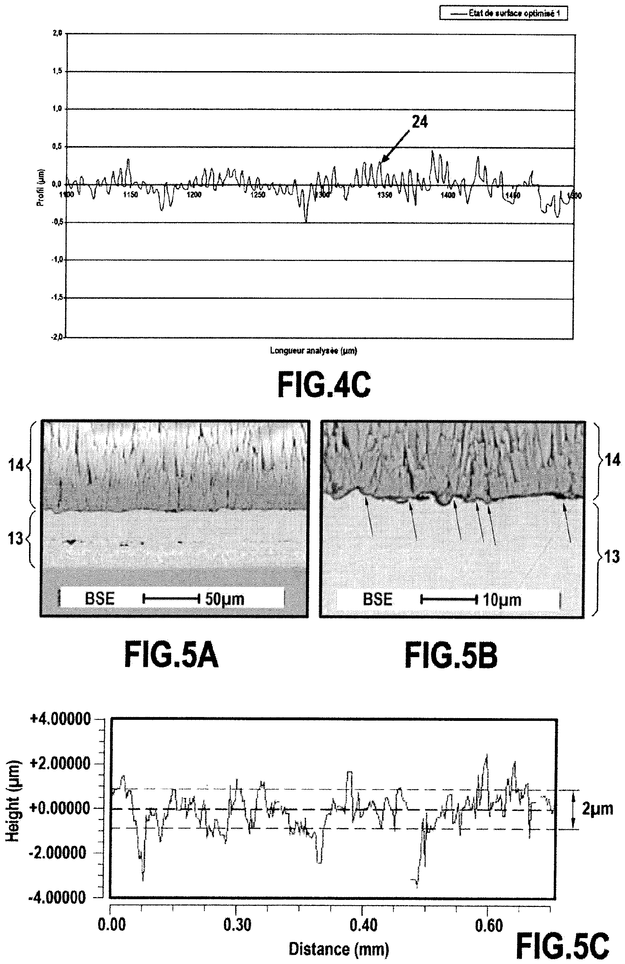

La courbe 24 de la figure 4C correspond au profil de rugosité de la sous-couche 13 telle qu'elle résulte d'une deuxième forme de mise en oeuvre de la méthode conforme à l'invention utilisant un deuxième procédé physico-chimique et/ou mécanique permettant de modifier l'état de surface avant dépôt de la couche céramique. Il s'agit d'un polissage mécanique. Comme il apparaît sur la courbe 24 : les écarts de niveau de la surface autour du profil moyen sont de bien moindre importance et en général de l'ordre de 0,5 µm au maximum.

En corrélant l'état de surface de la sous-couche 13 avec la survenue du phénomène de « rumpling » pour la barrière thermique 11 comportant à la fois la sous-couche 13 et la couche de céramique 14, le demandeur a réussi à établir différents critères de rugosité que doit remplir l'état de surface de la sous-couche 13 avant dépôt de la couche céramique pour que le phénomène de « rumpling » pour la barrière thermique 11 comportant à la fois la sous-couche 13 et la couche de céramique 14 soit très fortement retardé et/ou complètement inhibé.

En effet, lorsqu'on évite la présence de défauts de grande amplitude, on évite la présence de points d'initiation de fissures et de zones privilégiées de déformations néfaste, en particulier le phénomène de « rumpling », notamment s'agissant de la sous-couche 13.

Ainsi, par exemple, le demandeur a établi une première condition consistant à limiter le nombre de défauts présentant un écart entre les crêtes supérieur ou égal à 2 µm est au maximum de 5 sur toute distance de 50 µm, l'écart entre les crêtes étant pris en compte entre le fond d'un creux et le sommet d'un pic.

Sur les figures 5A, 5B et 5C, il s'agit d'une barrière thermique de l'art antérieur pour laquelle l'état de surface de la sous-couche 13 ne respecte pas cette première condition. En effet, sur la figure 5C, il apparaît un nombre plus important que 5 de défauts présentent un écart entre les crêtes de plus de 2 µm (en l'occurrence 6 « gros défauts » repérés par une flèche sur la figure 5B).

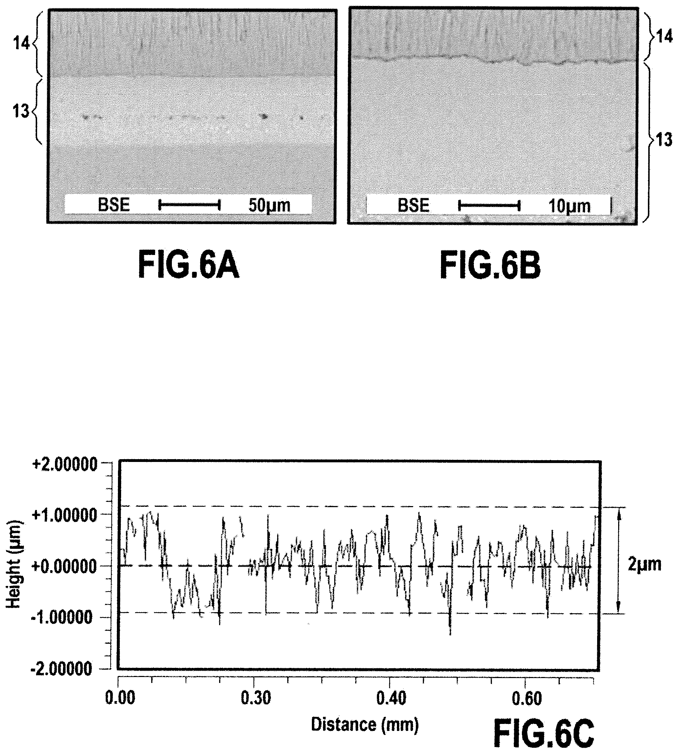

Sur les figures 6A, 6B et 6C, il s'agit d'une barrière thermique obtenue par la première forme de mise en oeuvre de la méthode conforme à l'invention utilisant le premier procédé physico-chimique et/ou mécanique et qui présente un état de surface de la sous-couche 13 respectant ladite première condition : sur la figure 6C, il apparaît seulement deux défauts présentant un écart entre les crêtes de plus de 2 µm (donc un nombre moins important que 5 de tels défauts).

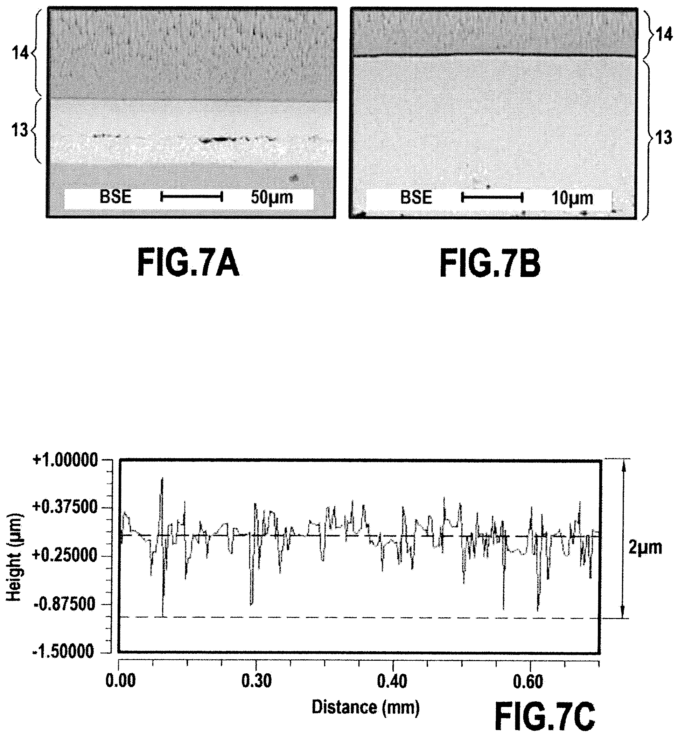

Sur les figures 7A, 7B et 7C, il s'agit d'une barrière thermique obtenue par la deuxième forme de mise en oeuvre de la méthode conforme à l'invention utilisant le deuxième procédé physico-chimique et/ou mécanique et qui présente un état de surface de la sous-couche 13 respectant également ladite première condition : l'état de surface visible sur la figure 7A est encore davantage régulier et proche d'une ligne rectiligne que dans le cas de la figure 6A. Sur la figure 7C, il n'apparaît aucun défaut présentant un écart entre les crêtes de plus de 2 µm (donc un nombre moins important que 5 de tels défauts).

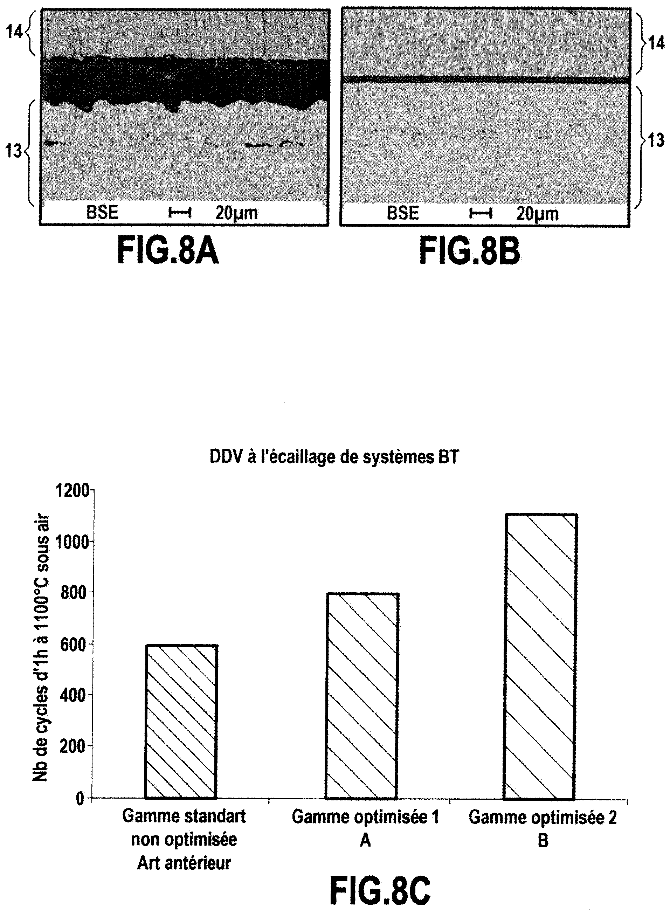

Sur les figures 8A et 8B, il s'agit respectivement d'une barrière thermique de l'art antérieur après service (1000 cycles à 1100°C) pour laquelle l'état de surface de la sous-couche 13 ne respecte pas cette première condition, et d'une barrière thermique obtenue par la deuxième forme de mise en oeuvre de la méthode conforme à l'invention utilisant le deuxième procédé physico-chimique et/ou mécanique et qui présente un état de surface de la sous-couche 13 respectant ladite première condition.

Les durées de vie à l'écaillage ont été mesurées pour des barrières thermiques conformes à l'art antérieur, ne respectant pas les conditions d'état de surface de la sous-couche 13 présente sous la couche de céramique, et pour des barrières thermiques obtenues par la mise en oeuvre de la méthode fabrication selon l'invention : la figure 8C montre les résultats pour des cycles d'une heure à 1100°C sous air.

Le premier test (à gauche sur la figure 8C) a porté sur un échantillon comportant une barrière thermique de l'art antérieur (visible sur les Figures 5A et 5B) qui a résisté environ 600 cycles.

Le deuxième test A (au centre sur la figure 8C) concerne un échantillon comportant une barrière thermique similaire à la précédente, hormis le fait qu'elle a été obtenue par première forme de mise en oeuvre de la méthode conforme à l'invention utilisant le premier procédé physico-chimique et/ou mécanique (visible sur les Figures 6A et 6B) de sorte qu'elle présente un état de surface de la sous-couche 13 respectant ladite première condition. Cette barrière thermique a résisté environ 800 cycles, soit une durée de vie augmentée de l'ordre de 30%.

Le troisième test B (à droite sur la figure 8C) concerne un échantillon comportant une barrière thermique similaire à celle du premier test, hormis le fait qu'elle a été obtenue par deuxième forme de mise en oeuvre de la méthode conforme à l'invention utilisant le deuxième procédé physico-chimique et/ou mécanique (visible sur les Figures 7A et 7B) de sorte qu'elle présente un état de surface de la sous-couche 13 respectant ladite première condition. Cette barrière thermique a résisté environ 1100 cycles, soit une durée de vie augmentée de l'ordre de 85%.

Afin d'obtenir l'absence ou le retard dans l'apparition du phénomène de « rumpling », le demandeur a fait ressortir le rôle important de l'état de surface de la sous-couche 13 en présence de la couche de céramique 14 pour former un ensemble constituant une barrière thermique apte à résister au phénomène de « rumpling ».

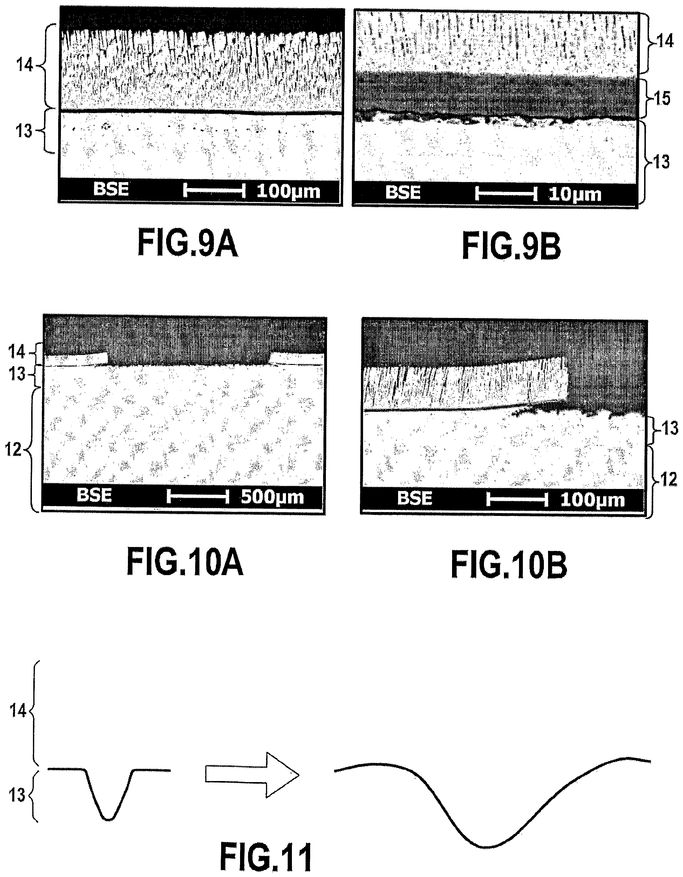

Ainsi, c'est ce qui ressort des figures 9A et 9B, constituées de vues micrographiques de barrière thermique après service pour différents grossissements et obtenues par deuxième forme de mise en oeuvre de la méthode conforme à l'invention utilisant le deuxième procédé physico-chimique et/ou mécanique.

Sur la figure 9A : aucun endommagement par « rumpling » n'est apparu au niveau de l'interface 16 entre la sous-couche 13 et la couche de céramique 14.

Sur la figure 9B, on voit que la couche d'alumine 15 reste dense, homogène et adhérente, malgré sa forte épaisseur.

Sur les figures 10A et 10B, il s'agit d'une barrière thermique obtenue par deuxième forme de mise en oeuvre de la méthode conforme à l'invention utilisant le deuxième procédé physico-chimique (polissage) de sorte qu'elle présente un état de surface de la sous-couche 13 respectant ladite première condition. Pour montrer le rôle indispensable de la couche de céramique 14, ces figures 10A et 10B illustrent, à deux grossissements différents, l'effet de l'absence de la couche de céramique 14 dans la zone centrale de la figure 10A et dans la partie droite de la figure 10B: à l'issue du cyclage à hautes températures, des ondulations sont apparues à l'emplacement de la sous-couche 13 non revêtue de la couche de céramique 14, tandis que ces ondulations sont totalement absentes dans les zones revêtues de la couche de céramique 14.

De cette manière, on comprend que les conditions à remplir pour atteindre cet objectif correspondent au cumul des deux conditions suivantes :
- état de surface de la sous-couche 13 présentant une rugosité contrôlée avec une densité surfacique de « gros défauts » limitée, et
- présence de la couche de céramique 14 sur la sous-couche 13 (directement sur la sous-couche 13 ou avec interposition d'une couche d'alumine 15).

La figure 11 illustre le phénomène de « rumpling » pour une zone de la sous-couche 13 non revêtue de la couche de céramique 14 : s'il y a au départ un défaut de surface de taille supérieure à la taille critique, après vieillissement en service à hautes températures, la forme de ce défaut s'accentue d'où une ondulation qui conduit à la rupture de l'interface 16 entre la sous-couche 13 et la couche de céramique 14. En particulier, avec des défauts de surface de la sous-couche 13 de taille supérieure à la taille critique :
- on retrouve des défauts de taille importante au niveau de la couche de céramique 14 (défauts au niveau des colonnes) qui est fragilisée dans sa résistance mécanique et sa tenue à forte température,
- de tels emplacements sont les lieux privilégiés de transformations de phases métallurgiques au sein de la barrière thermique, et
- ces emplacements constituent des zones propices à l'amorce de fissures.

Ainsi, il apparaît que la couche de céramique 14 est indispensable pour ne pas obtenir une dégradation très rapide de la barrière thermique 11, et permettre notamment à la fois une rigidification de l'empilement et une protection de la sous-couche 13, ce qui conduit, lorsque l'état de surface de départ de la sous-couche 13 remplit les conditions déterminées par le demandeur, à inhiber le phénomène de « rumpling ».

Grâce à un état de surface optimisé respectant l'une ou plusieurs des conditions déterminées par le demandeur, on obtient :
- la croissance d'une couche d'alumine 15 dense, régulière, qui adhère en tout point sur la sous-souche 13, d'où une protection physique complète de la sous-souche 13 par la couche d'alumine 15 et par la couche de céramique 14,
- une limitation du nombre de défauts dans la couche de céramique 14.

Les exemples cités ont porté sur des substrats à base de nickel, revêtues d'une sous-couche 13 de type NiAlPt, recouverte d'une couche d'alumine 15, elle-même surmontée d'une couche de céramique 14 constituée de zircone yttriée.

## Revendications

1. Méthode de fabrication d'une barrière thermique (11) recouvrant un substrat métallique en superalliage, ladite barrière thermique (11) comprenant au moins une sous-couche (13) et une couche de céramique (14), **caractérisée en ce que** l'on met en oeuvre l'étape suivante :
- on rectifie l'état de surface de la sous-couche (13) par au moins un procédé physico-chimique et/ou mécanique avant d'effectuer le dépôt de la couche de céramique (14) de sorte que le nombre de défauts présentant un écart entre les crêtes supérieur ou égal à 2 µm est au maximum de 5 sur toute distance de 50 µm, et on effectue le dépôt de la couche de céramique (14).

2. Méthode de fabrication selon la revendication 1, **caractérisée en ce que** le procédé physico-chimique et/ou mécanique engendre un état de surface de la sous-couche (13) tel que le nombre de défauts présentant une amplitude supérieure à 1 µm par rapport à la position moyenne de la face supérieure de la sous-couche (13) est au maximum de 5 sur toute distance de 50 µm.

3. Méthode de fabrication selon l'une quelconque des revendications précédentes, **caractérisée en ce que** le procédé physico-chimique et/ou mécanique engendre un état de surface de la sous-couche (13) tel que la rugosité Ra de la sous-couche (13) est comprise entre 0.05 µm et 3 µm, avec la rugosité Ra qui est l'écart moyen arithmétique par rapport à la ligne moyenne ou la moyenne intégrale des écarts en valeur absolue.

4. Méthode de fabrication selon l'une quelconque des revendications précédentes, **caractérisée en ce que** le procédé physico-chimique et/ou mécanique engendre un état de surface de la sous-couche (13) tel que la rugosité Ra de la sous-couche (13) est comprise entre 0.05 µm et 1 µm, avec la rugosité Ra qui est l'écart moyen arithmétique par rapport à la ligne moyenne ou la moyenne intégrale des écarts en valeur absolue.

5. Méthode de fabrication selon l'une quelconque des revendications précédentes, **caractérisée en ce que** le procédé physico-chimique et/ou mécanique engendre un état de surface de la sous-couche (13) tel que la rugosité Rz de la sous-couche (13) est inférieure à 10 µm, avec la rugosité Rz qui est la régularité, à savoir la moyenne des écarts totaux de rugosité "Rt" observés sur 5 longueurs, avec "Rt" l'écart total qui correspond à la dénivellation la plus importante entre le plus haut sommet d'un pic et le fond le plus bas d'un creux.

6. Méthode de fabrication selon l'une quelconque des revendications précédentes, **caractérisée en ce que** le procédé physico-chimique et/ou mécanique engendre un état de surface de la sous-couche (13) tel que l'un au moins parmi les critères suivants est respecté :
0 µm < Rk < 5 µm,
0 µm < Rvk < 3 µm,
0 µm < Rpk < 3 µm,
- 1 < Sk < 1, et
1 < Ek < 10,
avec les paramètres Rk, Rpk et Rvk calculés sur la base d'une courbe d'Abott, Rk étant la profondeur du profil écrêté qui représente la profondeur de rugosité centrale du profil, Rvk étant la profondeur de creux éliminés qui représente la profondeur moyenne des creux dépassant la partir centrale du profil et Rpk étant la hauteur des crêtes éliminées qui représente la hauteur moyenne des crêtes dépassant la partir centrale du profil, et avec Sk correspondant à la symétrie de la courbe de distribution d'amplitude et Ek le tracé global de référence.

7. Méthode de fabrication selon l'une quelconque des revendications précédentes, **caractérisée en ce que** le procédé physico-chimique et/ou mécanique appartient au groupe comprenant le sablage sec, le sablage humide, le polissage mécanique, le polissage électrolytique, et la tribofinition.

8. Pièce thermomécanique en superalliage comprenant une barrière thermique (11) obtenue selon la méthode selon l'une quelconque des revendications précédentes.

9. Pièce thermomécanique en superalliage selon la revendication 8, **caractérisée en ce que** la sous-couche (13) est une sous-couche (13) métallique constituée d'un aluminiure de nickel contenant éventuellement un métal choisi parmi le platine, le chrome, le palladium, le ruthénium, l'iridium, l'osmium, le rhodium, ou un mélange de ces métaux et/ou un élément réactif choisi parmi le zirconium (Zr), le cérium (Ce), le lanthane (La), le titane (Ti), le tantale (Ta), l'hafnium (Hf), le silicium (Si) et l'yttrium (Y), ou une sous-couche (13) métallique de type MCrAlY, M étant un métal choisi parmi le nickel, le cobalt, le fer ou un mélange de ces métaux, ou à base de Pt, ou encore une sous-couche (13) métallique correspondant à un revêtement de platine diffusé seul qui consiste en une matrice gamma-gamma prime de nickel cobalt avec du platine (Pt) en solution.

10. Pièce thermomécanique en superalliage selon la revendication 8 ou 9, **caractérisée en ce que** ladite sous-couche (13) est constituée d'un alliage apte à former une couche d'alumine protectrice par oxydation.

11. Pièce thermomécanique en superalliage selon l'une quelconque des revendications 8 à 10, **caractérisée en ce que** ladite couche de céramique (14) est à base de zircone yttriée comprenant une teneur molaire d'oxyde d'yttrium entre 4 et 12%.

12. Pièce thermomécanique en superalliage selon l'une quelconque des revendications 8 à 11, **caractérisée en ce que** ladite pièce est une chambre de combustion, une aube de turbine, un distributeur de turbine, et toute pièce thermomécanique susceptible d'être revêtue d'un système de barrière thermique.

## Patentansprüche

1. Verfahren zur Herstellung einer Wärmebarriere (11), die ein Metallsubstrat aus einer Superlegierung bedeckt, wobei die Wärmebarriere (11) zumindest eine Grundierungsschicht (13) und eine Keramikschicht (14) umfasst, **dadurch gekennzeichnet, dass** der folgende Schritt durchgeführt wird:
- Korrigieren der Oberflächenbeschaffenheit der Grundierungsschicht (13) mittels zumindest eines physikalisch-chemischen und/oder mechanischen Prozesses vor dem Ausführen der Abscheidung der Keramikschicht (14), sodass die Anzahl an Mängeln, die eine Abweichung zwischen den Erhebungen von mehr als oder gleich 2 µm darstellen, über die gesamte Strecke von 50 µm höchstens 5 beträgt, und Ausführen der Abscheidung der Keramikschicht (14).

2. Verfahren zur Herstellung nach Anspruch 1, **dadurch gekennzeichnet, dass** der physikalisch-chemische und/oder mechanische Prozess der Grundierungsschicht (13) eine Oberflächenbeschaffenheit verleiht, sodass die Anzahl an Mängeln, die eine Amplitude von mehr als 1 µm in Bezug auf die mittlere Position der Oberseite der Grundierungsschicht (13) darstellen, über die gesamte Strecke von 50 µm höchstens 5 beträgt.

3. Verfahren zur Herstellung nach einem der vorhergehenden Ansprüche, **dadurch gekennzeichnet, dass** der physikalisch-chemische und/oder mechanische Prozess der Grundierungsschicht (13) eine Oberflächenbeschaffenheit verleiht, sodass die Rauheit Ra der Grundierungsschicht (13) zwischen 0,05 µm und 3 µm beträgt, wobei die Rauheit Ra die arithmetische mittlere Abweichung in Bezug auf die Mittellinie oder der Integraldurchschnitt der Abweichungen als absoluter Wert ist.

4. Verfahren zur Herstellung nach einem der vorhergehenden Ansprüche, **dadurch gekennzeichnet, dass** der physikalisch-chemische und/oder mechanische Prozess der Grundierungsschicht (13) eine Oberflächenbeschaffenheit verleiht, sodass die Rauheit Ra der Grundierungsschicht (13) zwischen 0,05 µm und 1 µm beträgt, wobei die Rauheit Ra die arithmetische mittlere Abweichung in Bezug auf die Mittellinie oder der Integraldurchschnitt der Abweichungen als absoluter Wert ist.

5. Verfahren zur Herstellung nach einem der vorhergehenden Ansprüche, **dadurch gekennzeichnet, dass** der physikalisch-chemische und/oder mechanische Prozess der Grundierungsschicht (13) eine Oberflächenbeschaffenheit verleiht, sodass die Rauheit Rz der Grundierungsschicht (13) weniger als 10 µm beträgt, wobei die Rauheit Rz die Regularität ist, also der Durchschnitt der Gesamtabweichungen der Rauheit "Rt", die über 5 Längen beobachtet werden, wobei "Rt" die Gesamtabweichung ist, die dem größten Höhenunterschied zwischen dem höchsten Punkt einer Spitze und dem tiefsten Punkt einer Vertiefung entspricht.

6. Verfahren zur Herstellung nach einem der vorhergehenden Ansprüche, **dadurch gekennzeichnet, dass** der physikalisch-chemische und/oder mechanische Prozess der Grundierungsschicht (13) eine Oberflächenbeschaffenheit verleiht, sodass zumindest eines der folgenden Kriterien erfüllt ist:
0 µm < Rk < 5 µm,
0 µm < Rvk < 3 µm,
0 µm < Rpk < 3 µm,
- 1 < Sk < 1, und
1 < Ek < 10,
wobei die Parameter Rk, Rpk und Rvk auf der Grundlage einer Abbott-Kurve berechnet werden, wobei Rk die Tiefe des abgeschnittenen Profils ist, welche die Tiefe der mittleren Rauheit des Profils darstellt, Rvk die Tiefe der entfernten Vertiefungen ist, welche die mittlere Tiefe der Vertiefungen darstellt, die den mittleren Teil des Profils übersteigt, und Rpk die Höhe der entfernten Erhebungen ist, welche die mittlere Höhe der Erhebungen darstellt, die den mittleren Teil des Profils übersteigt, und wobei Sk der Symmetrie der Verteilungskurve der Amplitude und Ek dem globalen Referenzverlauf entspricht.

7. Verfahren zur Herstellung nach einem der vorhergehenden Ansprüche, **dadurch gekennzeichnet, dass** der physikalisch-chemische und/oder mechanische Prozess zu der Gruppe gehört, die Trockensandstrahlen, Nasssandstrahlen, mechanisches Polieren, elektrolytisches Polieren und Gleitschleifen umfasst.

8. Thermomechanisches Teil aus einer Superlegierung, das eine Wärmebarriere (11) umfasst, die gemäß dem Verfahren nach einem der vorhergehenden Ansprüche erhalten wird.

9. Thermomechanisches Teil aus einer Superlegierung nach Anspruch 8, **dadurch gekennzeichnet, dass** die Grundierungsschicht (13) eine metallische Grundierungsschicht (13) ist, die aus einem Nickelaluminid besteht, das gegebenenfalls ein Metall enthält, das aus Platin, Chrom, Palladium, Ruthenium, Iridium, Osmium, Rhodium oder einer Mischung aus diesen Metallen ausgewählt ist, und/oder ein reaktives Element, das aus Zirkonium (Zr), Cerium (Ce), Lanthan (La), Titan (Ti), Tantal (Ta), Hafnium (Hf), Silizium (Si) und Yttrium (Y) ausgewählt ist, oder eine metallische Grundierungsschicht (13) des Typs MCrAIY, wobei M ein Metall ist, das aus Nickel, Kobalt, Eisen oder einer Mischung aus diesen Metallen ausgewählt ist, oder auf der Basis von Pt, oder noch eine metallische Grundierungsschicht (13), die einer allein verteilten Platindeckschicht entspricht, die aus einer Gamma-Gamma-Prime-Matrix aus Nickelkobalt mit Platin (Pt) in Lösung besteht.

10. Thermomechanisches Teil aus einer Superlegierung nach Anspruch 8 oder 9, **dadurch gekennzeichnet, dass** die Grundierungsschicht (13) aus einer Legierung besteht, die dazu geeignet ist, durch Oxidation eine Schutzschicht aus Aluminiumoxid zu bilden.

11. Thermomechanisches Teil aus einer Superlegierung nach einem der Ansprüche 8 bis 10, **dadurch gekennzeichnet, dass** die Keramikschicht (14) auf der Basis von yttriertem Zirkonoxid ist, das einen molaren Gehalt an Yttriumoxid zwischen 4 und 12 % umfasst.

12. Thermomechanisches Teil aus einer Superlegierung nach einem der Ansprüche 8 bis 11, **dadurch gekennzeichnet, dass** das Teil eine Brennkammer, eine Turbinenschaufel, eine Turbinendüse und ein beliebiges thermomechanisches Teil ist, das mit einem Wärmebarrierensystem versehen werden kann.

## Claims

1. A fabrication method of fabricating a thermal barrier (11) covering a superalloy metal substrate, said thermal barrier (11) comprising at least an underlayer (13) and a ceramic layer (14), the method being **characterized in that** the following step is performed:
• the surface state of the underlayer (13) is smoothed by at least one physicochemical and/or mechanical process prior to depositing the ceramic layer (14) in such a manner that the number of defects presenting a peak-to-peak difference greater than or equal to 2 µm is at most five over any distance of 50 µm, and then depositing the ceramic layer (14).

2. A fabrication method according to claim 1, **characterized in that** the physicochemical and/or mechanical process gives rise to a surface state of the underlayer (13) such that the number of defects presenting an amplitude greater than 1 µm relative to the mean position of the top face of the underlayer (13) is at most five over any distance of 50 µm.

3. A fabrication method according to either preceding claim, **characterized in that** the physicochemical and/or mechanical process gives rise to a surface state of the underlayer (13) such that the roughness Ra of the underlayer (13) lies in the range 0.05 µm to 3 µm, where the roughness Ra is the mean difference, that is the arithmetic mean of the differences relative to the mean line or the integral mean of all of the differences in absolute value.

4. A fabrication method according to any preceding claim, **characterized in that** the physicochemical and/or mechanical process gives rise to a surface state of the underlayer (13) such that the roughness Ra of the underlayer (13) lies in the range 0.05 µm to 1 µm, where the roughness Ra is the mean difference, that is the arithmetic mean of the differences relative to the mean line or the integral mean of all of the differences in absolute value.

5. A fabrication method according to any preceding claim, **characterized in that** the physicochemical and/or mechanical process gives rise to a surface state of the underlayer (13) such that the roughness Rz of the underlayer (13) is less than 10 µm, where roughness Rz is regularity, that is the mean of the total differences of roughness "Rt" observed over five lengths, where "Rt" is the total difference that corresponds to the greatest difference in level between the top of the highest peak and the bottom of the deepest indentation.

6. A fabrication method according to any preceding claim, **characterized in that** the physicochemical and/or mechanical process gives rise to a surface state of the underlayer (13) such that at least one of the following criteria is satisfied:
0 µm < Rk < 5 µm;
0 µm < Rvk < 3 µm;
0 µm < Rpk < 3 µm;
- 1 < Sk < 1; and
1 < Ek < 10,
where the parameters Rk, Rpk, and Rvk are calculated on the basis of an Abott curve, Rk being the depth of the peak-limited profile that represents the depth of the central roughness of the profile, Rvk being the depth of the valleys that are eliminated and represents the mean depth of the valleys exceeding the central portion of the profile, and Rpk being the height of the peaks that have been eliminated and represents the mean height of the peaks exceeding the central portion of the profile, and where Sk corresponds to the symmetry of the amplitude distribution curve and Ek to the overall reference trace.

7. A fabrication method according to any preceding claim, **characterized in that** the physicochemical and/or mechanical process forms part of the group comprising dry sand blasting, wet sand blasting, mechanical polishing, electrolytic polishing, and tribofinishing.

8. A superalloy thermomechanical part including a thermal barrier (11) obtained by the method according to any preceding claim.

9. A superalloy thermomechanical part according to claim 8, **characterized in that** the underlayer (13) is a metal underlayer (13) constituted by nickel aluminide optionally containing a metal selected from platinum, chromium, palladium, ruthenium, iridium, osmium, rhodium, or a mixture of these metals, and/or a reactive element selected from zirconium (Zr), cerium (Ce), lanthanum (La), titanium (Ti), tantalum (Ta), hafnium (Hf), silicon (Si), and yttrium (Y), or a metal underlayer (13) of the MCrAlY type, where M is a metal selected from nickel, cobalt, iron, or a mixture of these metals, or based on Pt, or indeed a metal underlayer (13) corresponding to a coating of platinum diffused on its own and consisting in a gamma-gamma prime matrix of nickel cobalt with platinum (Pt) in solution.

10. A superalloy thermomechanical part according to claim 8 or claim 9, **characterized in that** said underlayer (13) is constituted by an alloy suitable for forming a protective layer of alumina by oxidation.

11. A superalloy thermomechanical part according to any one of claims 8 to 10, **characterized in that** said ceramic layer (14) is based on yttrified zirconia presenting a molar content of yttrium oxide lying in the range 4% to 12%.

12. A superalloy thermomechanical part according to any one of claims 8 to 11, **characterized in that** said part is a combustion chamber, a turbine blade, a turbine distributor, or any thermomechanical part suitable for being coated in a thermal barrier system.
